# EUROPEAN PATENT APPLICATION

(11) **EP 2 172 951 A1**
(43) Date of publication of application: **07.04.2010**
(21) Application number: 08790753.1
(22) Date of filing: 30.06.2008
(51) Int. Cl.: H01F 27/29

(54) **SURFACE MOUNTING COMPONENT**

(30) Priority: 19.07.2007 JP 2007187865
(71) Applicant: Sumida Corporation, Tokyo 103-8589 (JP)
(72) Inventor: SATO, Tsuyoshi, Tokyo 103-8259 (JP); MORIMOTO, Yasunori, Tokyo 103-8259 (JP)
(74) Representative: Schäfer, Matthias W.
(86) International application number: PCT/JP2008/061840
(87) International publication number: WO 2009/011217

(57) **Abstract**

There is provided a surface mounting component in which a shock with respect to constitution members thereof in a manufacturing process can be reduced and also, in which solder joining strength after the surface mounting is made to be adequate.

At least a portion of an end surface 5A2, 5B2 of an external terminal 5A, 5B of the surface mounting component which is joined with a mounting board is a cut surface formed by cutting off a connected member 7A which is connected to the external terminal 5A, 5B in a manufacturing process of the surface mounting component, and on the external terminal 5A, 5B, there is formed a concave portion 6 recessed from the end surface 5A2, 5B2.

## Description

### TECHNICAL FIELD

The present invention relates to a surface mounting component.

### BACKGROUND ART

With respect to a surface mounting component having a cut surface, which is cut off from a lead frame including a solder layer on the surface thereof, on an end surface of an external terminal, it sometimes happens that the cut surface thereof is oxidized, rusts easily and the solder wettability thereof is not preferable. For this reason, it sometimes happens that solder joining is not performed properly between a land on a mounting board on which the surface mounting component is mounted and the cut surface of the external terminal, and joining strength of the solder between the surface mounting component after being surface-mounted on the mounting board and the mounting board is lowered. Then, there has been proposed a technology in which the joining strength depending on the solder is heightened by providing a concave and convex portion on the side surface of the external terminal and thereby increasing a contact area between a portion formed with the solder layer of the external terminal and the mounting board (see Patent Document 1).

Patent Document 1: Japanese unexamined patent publication No. 2006-186075

### DISCLOSURE OF THE INVENTION

However, even if a concave and convex portion is not provided on the side surface of the external terminal, the joining strength by the solder at the side surface portion of the external terminal after being surface-mounted is originally adequate. Accordingly, it is difficult to expect a large effect of heightening the joining strength depending on a fact that a concave and convex portion is to be provided.

Also, the surface mounting component is generally manufactured by using a lead frame. For this reason, when carrying out the cutting of the lead frame in a manufacturing process of the surface mounting component, shock is applied to the members constituting the surface mounting component. It is conceivable that the surface mounting component will be damaged by the shock thereof.

Then, the problem of the present invention is to provide a surface mounting component in which it is possible to reduce shock with respect to the constitution members in the manufacturing process and also, in which it is possible to make the joining strength of the solder after the surface mounting be adequate.

In order to solve the problem mentioned above, in a surface mounting component having an external terminal applied with a plate coating process, the present invention is **characterized in that** at least one surface among the side surfaces of the external terminal is a cut surface which is formed by cutting off a connected member connected to the external terminal in a manufacturing process of the surface mounting component and from which a base material of the external terminal is exposed; and a surface which is recessed from the end surface and also which is applied with a plate coating process is formed at somewhere of the end surface having aforesaid cut surface.

In the present invention, at least one surface among the side surfaces of the external terminal is a cut surface which is formed by cutting off a connected member connected to the external terminal in a manufacturing process of the surface mounting component from the external terminal and from which a base material of the external terminal is exposed. Here, a surface which is recessed from the end surface is formed at somewhere of the end surface having this cut surface. Then, on this surface recessed from the end surface, there is formed a low melting point metal layer of solder, Ni plating, Cu plating or the like depending on a plate coating process.
Consequently, with respect to the surface which is recessed from the end surface and also which is applied with a plate coating process, it becomes possible to make the wettability of the low melting point metal be preferable. As a result thereof, it becomes possible to make the joining strength of the low melting point metal after the surface mounting of the surface mounting component be adequate.

In addition, in the present invention, there is formed, on the end surface which becomes a cut surface at least for a portion thereof, a surface which is recessed from this end surface and also which is applied with a plate coating process (hereinafter, there is a case of being referred to as "concave portion"), so that when cutting off the connected member, the cut of the portion corresponding to the concave portion becomes unnecessary. For this reason, the strength necessary for the cut becomes adequate even if it is small. Accordingly, it becomes possible to reduce the shock with respect to the constitution members of the surface mounting component in the manufacturing process of the surface mounting component.

Also, in the present invention, it is preferable for the cut surface to be formed by cutting the external terminal in a state of being connected with the connected member from the connected member after the plate coating process is applied and it is preferable for the surface which is recessed from the end surface and also which is applied with a plate coating process to be formed by being applied with the plate coating process after being cut so as to be recessed from the end surface.
By forming the surface which is recessed from the cut surface and the end surface and also which is applied with a plate coating process in such a procedure, it happens that a plate coating layer is already formed on the surface recessed from the end surface at the time point when the connected member is cut off from the external terminal. Consequently, it is not necessary to newly apply a plating process after the connected member is cut off.

In the present invention, it is preferable for the surface which is recessed from the end surface and also which is applied with a plate coating process to be formed plane-symmetrically by setting a plane surface passing through the center of the end surface and being perpendicular to the surface of the mounting board and the end surface as a symmetry plane. When constituting like this, the concave portion in which the wettability of the low melting point metal becomes preferable can be arranged symmetrically on the end surface, so that it becomes possible to uniform the stress which the low melting point metal in a melting state on an occasion of the mounting receives and it becomes possible to repress a break caused by melting or the like which is caused by a phenomenon that the stress is applied excessively to a partially melted low melting point metal. For this reason, it becomes possible to stabilize the joining work of the low melting point metal.

In the present invention, it is preferable for the surface which is recessed from the end surface and also which is applied with a plate coating process to be formed in a curved surface shape. When constituting like this, for example, in case of forming the external terminal by using a die, the abrasion of the die can be repressed, so that it becomes possible to form the concave portion easily.

As mentioned above, in the surface mounting component of the present invention, it becomes possible to reduce the shock with respect to the constitution members in the manufacturing process and also, it becomes possible to make the joining strength of the low melting point metal after the surface mounting be adequate.

### BRIEF DESCRIPTION OF DRAWINGS

FIG. 1 is a vertical cross-sectional view of a front elevational view of a surface mounting component relating to an exemplified embodiment of the present invention;
FIG. 2A is a plan view of a portion of an external terminal of the surface mounting component shown in FIG. 1, and FIG. 2B is a left side view of FIG. 2A;
FIG. 3 is a plan view after a bobbin is insert-molded onto a lead frame relating to an exemplified embodiment of the present invention;
FIG. 4 is a perspective view of a state in which the lead frame is cut from the state shown in FIG. 3;
FIG. 5 is a plan view of the portion of the external terminal of a state in which the surface mounting component shown in FIG. 2A is mounted on a mounting board;
FIG. 6A is a view showing a state in which external terminals and the frame bodies of the lead frame of the surface mounting component relating to an exemplified embodiment of the present invention are connected by means of connection portions for connecting both the sides thereof, and FIG. 6B is a view showing a state after root portions of the connecting portions between the connection portions and the external terminals shown in FIG. 6A are cut;
FIG. 7 is a plan view of the external terminal portion of a state in which the surface mounting component relating to an exemplified embodiment of the present invention shown in FIG. 6B is mounted on a mounting board;
FIG. 8A is a view showing a state in which the external terminal and the frame body of the lead frame of the surface mounting component relating to an exemplified embodiment of the present invention are connected by means of a connection portion for connecting both the sides thereof, and FIG. 8B is a plan view of the external terminal portion of a state in which the surface mounting component relating to an exemplified embodiment of the present invention shown in FIG. 8A is mounted on a mounting board; and
FIG. 9A is a view showing a state in which the external terminal and the frame body of the lead frame of the surface mounting component relating to an exemplified embodiment of the present invention are connected by means of a connection portion for connecting both the sides thereof, and FIG. 9B is a plan view of the external terminal portion of a state in which the surface mounting component relating to an exemplified embodiment of the present invention shown in FIG. 9A is mounted on a mounting board.

### DESCRIPTION OF REFERENCE NUMERALS

1, 1A: surface mounting component
5A, 5B, 5C, 5D, 5E, 5F, 5G, 5H: external terminal
5A2, 5B2: (end surface, cut surface)
5C2, 5D2, 5E2, 5F2: cut surface
5C3, 5D3, 5E3, 5F3, 5G3: end surface
6, 6A: concave portion
7, 7B: lead frame

### BEST MODE FOR CARRYING OUT THE INVENTION

Hereinafter, exemplified embodiments of the present invention will be explained.

### (Constitution of Surface Mounting Component)

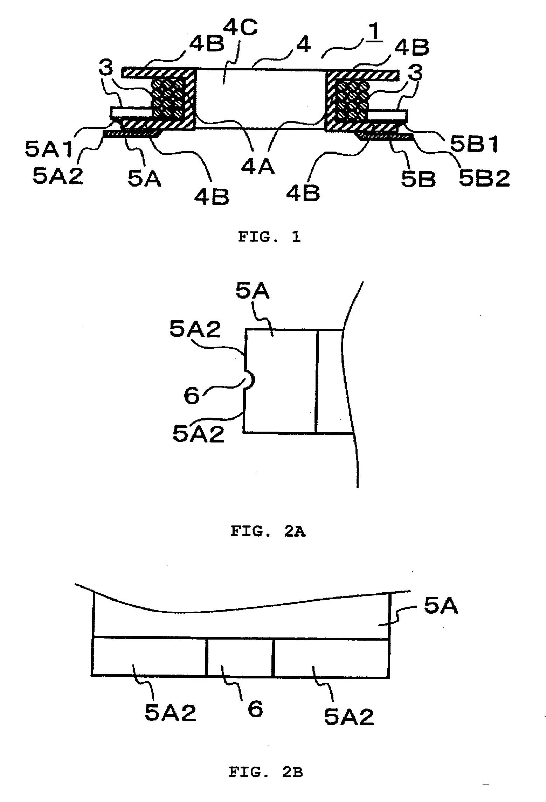

FIG. 1 is a vertical cross-sectional view of a front elevational view of a surface mounting component 1 relating to an exemplified embodiment of the present invention. The surface mounting component 1 of this exemplified embodiment is an air-core coil without a core and as shown in FIG. 1, the surface mounting component 1 is provided with a conducting wire 3, a bobbin 4 on which the conducting wire 3 is wound, external terminals 5A, 5B to which both the sides of the conducting wire 3 are connected, and connection portions 5A1, 5B1. Also, the external terminals 5A, 5B and the connection portions 5A1, 5B1 are connected through buried portions (illustration omitted) arranged in the inside of the bobbin 4.

The conducting wire 3 is, for example, a copper wire covered by an insulating film. The bobbin 4 is constituted by a resin and forms a cylindrical shape having flanges. More specifically, on both the sides in the axis direction of the bobbin 4, there are formed flange portions 4B which are protruded from an outer circumferential surface 4A toward the outside in the radial direction. Also, on the inside in the radial direction of the bobbin 4, there is formed a cylindrical shaped cavity 4C. As mentioned above, the external terminal 5A and the connection portion 5A1, and the external terminal 5B and the connection portion 5B1 are connected through buried portions. These buried portions are sealed by the resin which constitutes the bobbin 4. The external terminals 5A, 5B and the connection portions 5A1, 5B1 are exposed while being fixed by the resin of the bobbin 4. The conducting wire 3 is wound by a plurality of times along the outer circumferential surface 4A between the flange portions 4B formed on both the sides of the bobbin 4. One end of the conducting wire 3 is electrically connected to the connection portion 5A1 and fixed in a state in which the insulating film is removed. The other end of the conducting wire 3 is electrically connected to the connection portion 5B1 and fixed in a state in which the insulating film is removed.

The external terminals 5A, 5B are arranged on the bottom surface side of the surface mounting component 1 and concurrently, are protruded toward the outsides in the radial directions of the bobbin 4. End surfaces of the external terminals 5A, 5B in the protrusion directions are formed as top-end surfaces 5A2, 5B2 of the external terminals 5A, 5B. As mentioned above, the external terminal 5A is connected with the connection portion 5A1 and is electrically conducted. Also, the external terminal 5B is connected with the connection portion 5B1 and is electrically conducted. Also, the connection portion 5A1 and the connection portion 5B1 are electrically connected through the conducting wire 3.

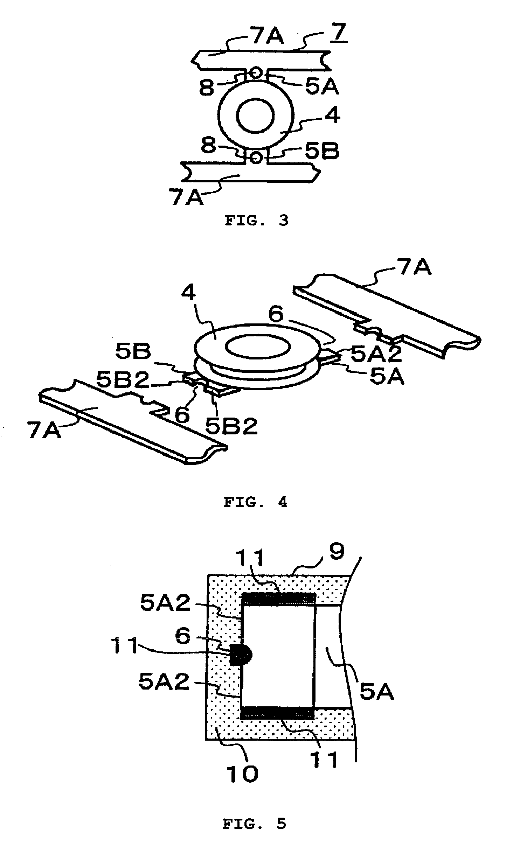

The external terminals 5A, 5B and the connection portions 5A1, 5B1 are formed by a base material of a stainless-steel metal plate, and solders are coated on the surfaces thereof (illustration omitted). However, the top-end surfaces 5A2, 5B2 of the external terminals 5A, 5B are, as mentioned later, cut surfaces formed by cutting off frame bodies 7A which constitute a lead frame 7 (see FIG. 3), so that solders are not coated on the top-end surfaces 5A2, 5B2. In order to describe this matter in detail, a plan view of the portion of the external terminal 5A of the surface mounting component 1 shown in FIG. 1 is shown in FIG. 2A and a left side view thereof is shown in FIG. 2B. The external terminal 5A is formed with a concave portion 6 which is recessed from a center portion of the top-end surface 5A2 toward an anti-protrusion direction of the external terminal 5A. Specifically, the external terminal 5A is formed with a concave portion 6 which is plane-symmetrical by setting a plane surface passing through the center of the top-end surface 5A2 and being perpendicular to a mounting board mounted with the surface mounting component 1 and the top-end surface 5A2 as a symmetry plane. This concave portion 6 is formed in a semi-cylindrical shape. On an inner wall surface of the concave portion 6, there is coated the solder. However, on the top-end surface 5A2, there is not coated the solder. The external terminal 5B has a similar constitution as that of the external terminal 5A, so that the explanation of the external terminal 5B will be omitted. It should be noted that the external terminal 5A, 5B is, as mentioned later, fixed to a land 9 (see FIG. 5) of the mounting board by means of solder 10.

### (Manufacturing Method of Surface Mounting Component)

A manufacturing method of the surface mounting component 1 constituted as mentioned above will be explained hereinafter. First, a lead frame 7 is formed. Specifically, a base material composed of a stainless plate is applied with a bending process & punching process for a predetermined shape and thereafter, a solder plating process is applied to the surface and the lead frame 7 is formed. Depending on these processes, there are formed on the lead frame 7 with frame bodies 7A or the like for mutually connecting portions which become the external terminals 5A, 5B afterward; portions which become the connection portions 5A1, 5B1; portions which become buried portions and portions which become the external terminals 5A, 5B (see FIG. 3). Also, on the lead frame 7, there are formed circle shaped through-holes 8 at the boundary portions between the frame bodies 7A and the portions which become the external terminals 5A, 5B afterward by a punching process mentioned above (see FIG. 3). The inner wall surface of this through-hole 8 is coated with the solder formed by the solder plating process mentioned above.

It should be noted in this exemplified embodiment that the frame bodies 7A are connected with the external terminals 5A, 5B (specifically, portions which become external terminals 5A, 5B) (see FIG. 3). More specifically, in this exemplified embodiment, the frame bodies 7A are connected members which are connected to the external terminals 5A, 5B in the manufacturing process of the surface mounting component 1. Also, for the lead frame 7, two pieces of frame bodies 7A are arranged in parallel in a state in which a predetermined distance is spaced therebetween and on the lead frame 7, there are formed a plurality of supporting frame bodies (illustration omitted) for mutually connecting these two pieces of frame bodies 7A. These supporting frame bodies achieve a function for determining a relative position between the external terminal 5A and the external terminal 5B and a function for determining a relative position between the connection portion 5A1 and the connection portion 5B1.

Thereafter, depending on the insert molding which performs a resin mold by arranging a portion of the lead frame 7 in a die, the bobbin 4 is integrally formed with the lead frame 7. FIG. 3 is a plan view of a state in which the bobbin 4 is insert-molded with respect to the lead frame 7. It should be noted in FIG. 3 that illustration is omitted with respect to the connection portions 5A1, 5B1 and the supporting frame bodies. In this insert molding, the lead frame 7 is arranged such that the buried portions are buried under the bobbin 4, and the external terminals 5A, 5B and the connection portions 5A1, 5B1 are exposed from the bobbin 4. Specifically, in the insert molding, first, a portion of the lead frame 7 which becomes the buried portion is arranged in the molding die and thereafter, an epoxy resin is filled in the molding die thereof. Also, thereafter, the epoxy resin is cured. Then, there is formed a shape of the bobbin 4 which is modeled after the shape of the molding die and concurrently, the buried portion is buried under the bobbin 4.

Thereafter, the bobbin 4 having the external terminals 5A, 5B is cut from the lead frame 7. FIG. 4 is a perspective view of a state in which the lead frame 7 is cut along straight lines which are in parallel with the longitudinal directions of the frame bodies 7A and also which pass through approximately the centers of the through-holes 8 after the insert molding mentioned above. On the occasion of this cut, a press-cutting cutter is used. Owing to this cut, the frame bodies 7A are cut off and the top-end surface 5A2 of the external terminal 5A and the top-end surface 5B2 of the external terminal 5B are exposed. More specifically, the cut surfaces which are formed after the frame bodies 7A are cut off by this cut will become the top-end surfaces 5A2, 5B2. In this manner, in this exemplified embodiment, the whole top-end surfaces 5A2, 5B2 become the cut surfaces. Also, owing to this cut, portions corresponding to the through-holes 8 become the concave portions 6. It should be noted that even after this cut, the inner wall surface of the concave portion 6 is coated with the solder formed by the solder plating process mentioned above.

Thereafter, one end of the conducting wire 3 is locked at the connection portion 5A1 and this locking portion is soldered and fixed. Depending on this soldering, the conducting wire 3 and the connection portion 5A1 are connected electrically. In that state, the conducting wire 3 is wound along the outer circumferential surface 4A of the bobbin 4. After being wound-around by a desired amount of times, the conducting wire 3 is cut. Then, the cut portion thereof is locked at the connection portion 5B1 and this locking portion is soldered and fixed. Depending on this soldering, the conducting wire 3 and the connection portion 5B1 are connected electrically. Going through the processes above, the surface mounting component 1 of this exemplified embodiment is manufactured.

It should be noted that the solder plating process is not applied with respect to the bobbin 4 having the external terminals 5A, 5B, which was cut from the lead frame 7. For this reason, as mentioned above, the solder is not coated on the top-end surfaces 5A2, 5B2 of the external terminals 5A, 5B.

### (Main Effect of this Exemplified Embodiment)

In the surface mounting component 1 of this exemplified embodiment, the concave portions 6 which are recessed from the top-end surfaces 5A2, 5B2 are formed with respect to the external terminals 5A, 5B. Accordingly, when cutting off the external terminals 5A, 5B from the lead frame 7 (when the frame bodies 7A are cut off from the external terminals 5A, 5B), it is needless to cut portions corresponding to the concave portions 6 (through-holes 8). For this reason, the strength necessary for the cut becomes adequate even if it is small. Accordingly, it is possible to reduce a shock with respect to the constitution members of the surface mounting component 1 in the manufacturing process of the surface mounting component 1. As a result thereof, for example, within the area of the lead frame 7 which is bending-processed into a predetermined shape beforehand, it become possible to prevent deformation of the portions corresponding to the external terminals 5A, 5B and the connection portions 5A1, 5B1, and the manufacturing process of the surface mounting component 1 is stabilized. Also, it becomes possible to prevent deformation of the portions corresponding to the external terminals 5A, 5B and therefore, the mounting state of the surface mounting component 1 to the mounting board becomes stable.

In the surface mounting component 1 of this exemplified embodiment, the solder is coated on the inner wall surface of the concave portion 6. For this reason, it is possible for the inner wall surface of the concave portion 6 to have excellent solder wettability. Consequently, it become possible for the solder joining strength after the surface mounting of the surface mounting component 1 to be adequate. The effect of this exemplified embodiment will be explained specifically by using FIG. 5.

In FIG. 5, there is shown a plan view in a state of mounting the external terminal 5A shown in FIG. 2A on a mounting board. In FIG. 5, a whole surface of a land 9 which the mounting board includes and on which the surface mounting component 1 is to be mounted is coated by the solder 10 which is used on an occasion of the mounting. Here, the solder plating layer is not formed on the top-end surface 5A2 of the external terminal 5A within the portions by which the land 9 and the external terminal 5A contact, so that the solder fillet 11 is not formed thereon. On the other hand, on the side surface of the external terminal 5A and on the inner wall surface of the concave portion 6, there are formed solder plating layers, so that the solder fillets 11 are formed on those portions. In this manner, the concave portions 6 contribute for heightening the joining strength between the top-end surfaces 5A2, 5B2 of the external terminals 5A, 5B and the mounting board.

In this exemplified embodiment, the concave portion 6 is formed plane-symmetrically by setting the plane surface passing through the center of the top-end surface 5A2, 5B2 and being perpendicular to the surface of the mounting board and the top-end surface 5A2, 5B2 as a symmetry plane. For this reason, after mounting the surface mounting component 1 on the mounting board, portions on which the solder fillets 11 are formed are arranged symmetrically on the side of the top-end surface 5A2, 5B2. Consequently, on the side of the top-end surface 5A2, 5B2, it becomes possible to eliminate unbalance of the solder joining strength with respect to the center of the top-end surface 5A2, 5B2. As a result thereof, it is possible to equalize the stress which the melting solder receives on an occasion of the mounting and it becomes possible to repress a break caused by melting or the like which is caused by a phenomenon that the stress is applied to a portion of the melting solder excessively. For this reason, it becomes possible to stabilize the solder joining work in which the tombstone phenomenon can be prevented or the like.

In this exemplified embodiment, the concave portion 6 is formed in a curved surface shape, so that it is possible to repress abrasion of a die which is used for the punching process when forming the lead frame 7 and the formation of the concave portion 6 becomes easy.

### (Another Exemplified Embodiment)

In the exemplified embodiment mentioned above, for the external terminal 5A, 5B, there is singularly formed a concave portion 6 which is recessed from the top-end surface 5A2, 5B2. However, it is also allowed for the external terminal to be provided with two or more concave portions which are recessed from the end surface of the external terminal. Also, in the exemplified embodiment mentioned above, the whole top-end surface 5A2, 5B2 is formed as the cut surface. However, it is also allowed even if somewhere of the end surface of the external terminal is made to be the cut surface.

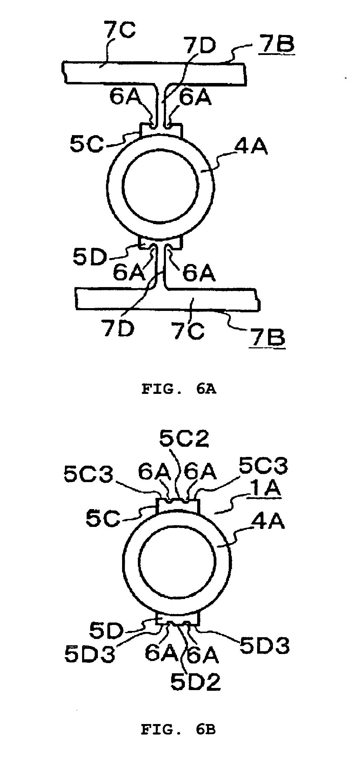

In FIG. 6, as a modified example of this exemplified embodiment, there is shown a surface mounting component 1A in which concave portions 6A are formed by an amount of two portions for every one of the external terminals 5C, 5D. As shown in FIG. 6A, in this modified example, frame bodies 7C of a lead frame 7B and the external terminals 5C, 5D are connected by means of connection bodies 7D for connecting both the sides. On both the sides of the connecting portion between this connection body 7D and the external terminal 5C, 5D, there are formed semi-cylindrical shaped concave portions 6A which are recessed to the side of the external terminal 5C, 5D (more specifically, recessed to the anti-protrusion direction of the external terminal 5C, 5D). Also, the width of the external terminal 5C, 5D (width in the right and left direction of FIG. 6A) is designed to be wider than the width of the connection body 7D. Further, the connection bodies 7D are connected to the external terminals 5C, 5D at the center positions of the external terminals 5C, 5D in the right and left direction of FIG. 6A. The concave portion 6A is, similarly as the exemplified embodiment mentioned above, formed when a metal plate is applied with the bending process & punching process for a predetermined shape. Then, the solder plating layer is formed on the surface thereof. Then, the solder plating layer is formed also on the inner wall surface of the concave portion 6A. In addition, the plating layers are formed also on the end surfaces of the external terminal 5C, 5D, which are arranged on both the sides of the concave portion 6A. Thereafter, by applying the insert molding similarly as the exemplified embodiment mentioned above, the bobbin 4A is formed.

In FIG. 6B, there is shown the surface mounting component 1A formed in a manner in which root portions of the connecting portions between the connection bodies 7D and the external terminals 5C, 5D shown in FIG. 6A are cut and thereafter, similarly as the exemplified embodiment mentioned above, the conducting wire 3 is wound around the bobbin 4A. As shown in FIG. 6B, the concave portions 6A recessed from the end surfaces 5C3, 5D3 in the protrusion directions of the external terminals 5C, 5D are formed at the external terminals 5C, 5D in a manner of being lined up by two portions on both the sides respectively. Also, the surfaces between these lined-up two concave portions 6A within the areas of the end surfaces 5C3, 5D3 are cut surfaces 5C2, 5D2 formed by being cut off from the lead frame 7B (more specifically, formed by a fact that the connection bodies 7D are cut off). More specifically, in this modified example, portions of the end surfaces 5C3, 5D3 are the cut surfaces 5C2, 5D2 which are formed by a fact that the connection bodies 7D are cut off.

It should be noted that it is also allowed for the end surfaces 5C3, 5D3 and the cut surfaces 5C2, 5D2 to be formed either of on the same plane surfaces or on different plane surfaces. Also, in this modified example, the connection bodies 7D are connected members which are connected to the external terminals 5C, 5D in the manufacturing process of the surface mounting component 1A.

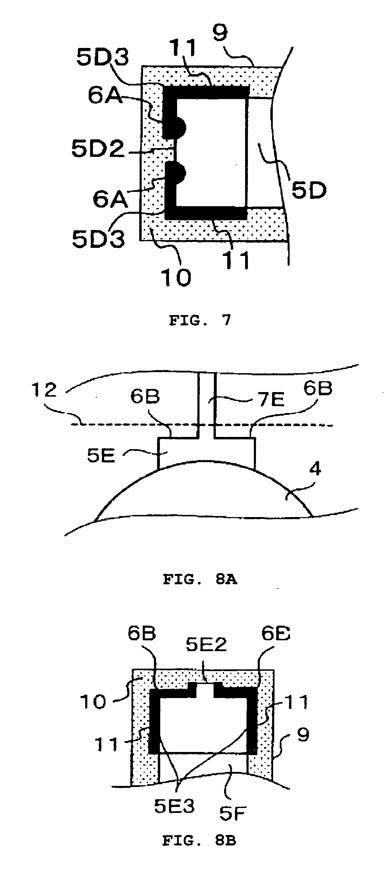

In FIG. 7, there is shown, similarly as FIG. 5, a plan view of the external terminal 5D portion of a state in which the surface mounting component 1A is mounted on the mounting board. There are formed the solder fillets 11 at the concave portions 6A. In addition, the solder fillets 11 are formed also on the end surfaces 5D3 except the cut surface 5D2 of the external terminal 5D. Accordingly, the solder joining strength after the surface mounting of the surface mounting component 1A becomes adequate. Also, in a state of sandwiching the cut surface 5C2, 5D2, the lined-up two concave portions 6A are formed plane-symmetrically by setting the plane surface passing through the center of the end surface 5C3, 5D3 and being perpendicular to the surface of the mounting board and the end surface 5C3, 5D3 as a symmetry plane. For this reason, after mounting the surface mounting component 1A on the mounting board, the portions on which the solder fillets 11 are formed are arranged symmetrically on the side of the end surface 5C3, 5D3. Consequently, on the sides of the end surfaces 5C3, 5D3, it is possible to equalize the stress which the melting solders receive on an occasion of the mounting and it is possible to repress the break caused by melting or the like which is caused by a phenomenon that the stress is applied to a portion of the melting solder excessively.

In the exemplified embodiment mentioned above, the top-end surfaces 5A2, 5B2 which are the end surfaces in the protrusion directions of the external terminals 5A, 5B are formed as the cut surfaces with respect to the lead frame 7. However, it is also allowed for the end surface in the direction perpendicular to the protrusion direction of the external terminal 5A, 5B (more specifically, end surface formed at the upper or lower end in FIG. 2A) to be formed as a cut surface. In this case, it is enough if a concave portion corresponding to the concave portion 6 is formed on an end surface in the direction perpendicular to the protrusion direction of the external terminal 5A, 5B, on which the cut surface exists.

In the exemplified embodiment mentioned above, the external terminals 5A, 5B are protruded toward the outside in the radial direction of the bobbin 4. However, it is also allowed for the external terminals 5A, 5B to be protruded toward the inside in the radial direction of the cylindrically shaped bobbin 4.

In this case, it is allowed for the lead frame 7 to be formed such that the external terminals 5A, 5B are connected to the frame bodies 7A of the lead frame 7 or it is also allowed for the lead frame 7 to be formed such that the connection portions 5A1, 5B1 are connected to the frame bodies 7A of the lead frame 7.

In addition, in this case, it is also allowed to form engagement pieces for stabilizing the lead frame 7 on an occasion of the insert molding at the front-ends of the external terminals 5A, 5B. In case of forming the engagement pieces at the front-ends of the external terminals 5A, 5B, these engagement pieces are cut in a predetermined process after the insert molding, so that the end surfaces in the protrusion directions of the external terminals 5A, 5B become the cut surfaces. Consequently, in this case, in order to heighten the solder joining strength of the surface mounting component 1, the concave portions corresponding to the concave portions 6 are formed on the end surfaces in the protrusion directions of the external terminals 5A, 5B. It should be noted in this case that the engagement pieces become connected members which are connected to the external terminals 5A, 5B in the manufacturing process of the surface mounting component 1.

In the exemplified embodiment mentioned above, the concave portion 6 is formed plane-symmetrically by setting a plane surface passing through the center of the top-end surface 5A2, 5B2 and being perpendicular to the surface of the mounting board mounted with the surface mounting component 1 and the top-end surface 5A2, 5B2 as a symmetry plane. However, in case of the surface mounting component 1 or the like in which it is difficult for the tombstone phenomenon or the like to occur depending on the existence of the bobbin 4, it is not necessary for the concave portion to be formed plane-symmetrically in this manner.

Also, in the exemplified embodiment mentioned above, the concave portion 6 is formed in a semi-cylindrical shape. However, it is also allowed for the shape of the concave portion 6 to be formed in a square-rod shape, a roundish square-rod shape, a semi elliptical shape or the like. It should be noted in case of forming the concave portion 6 by the punching process mentioned above that in order to repress abrasion of the die used in the punching process and to form the concave portion 6 easily, it is preferable for the concave portion 6 to be formed in a curved surface shape of a semi-cylindrical shape, a roundish square-rod shape, a semi elliptical shape or the like. Also, it is not necessary for the concave portion 6 to be formed so as to be recessed, as shown in FIG. 2B, from the whole area in the up and down direction (direction perpendicular to the surface of the mounting board) of the top-end surface 5A2, 5B2 and for example, it is also allowed to form the top-end surface 5A2, 5B2 on the upper side and/or on the lower side of the concave portion 6.

Also, in the exemplified embodiment mentioned above, the conducting wire 3 is wound around after cutting off the bobbin 4 from the lead frame 7. However, it is also allowed to wind around the conducting wire 3 before cutting off the bobbin 4 from the lead frame 7. Also, in the exemplified embodiment mentioned above, the surface mounting component 1 is an air-core coil. However, it is also allowed for the surface mounting component 1 to be a coil selected from various kinds of core coils, toroidal coils and the like. Also, other than the coil, it is also allowed for the surface mounting component 1 to be a passive component of a capacitor, a resistor or the like, an active component of a transistor, a diode, an operational amplifier or the like and alternatively, to be a compound electric component in which those components above are combined by an amount of two or more kinds.

In the exemplified embodiment mentioned above, the surface mounting component 1 is manufactured by using insert molding, but it may also be manufactured by using a method other than the insert molding. For example, it is also allowed for the surface mounting component to be manufactured according to a process in which a component obtained by winding a conducting wire on a drum is joined with the lead frame and thereafter, the lead frame will be cut.

In the exemplified embodiment mentioned above, a solder plating layer is formed on the surface of the lead frame 7. However, a low melting point metal layer of a solder or the like may not be formed on the surface of the lead frame 7. Also, it is also allowed for the low melting point metal layer to be a so-called lead-free solder or the like which is composed of an alloy selected from single tin, tin-silver-copper-based material, tin-zinc-bismuth-based material, tin-zinc-aluminum-based material and the like other than a solder composed of an alloy of tin and lead, which is usually used.

In the exemplified embodiment mentioned above, the lead frame 7, the external terminals 5A, 5B and the connection portions 5A1, 5B1 are formed by a base material of a stainless-steel metal plate. However, it is also allowed for this base material to be composed of another material such as a phosphor bronze and the like.

In the exemplified embodiment mentioned above, the material of the bobbin 4 is selected to be an epoxy resin. However, the material of the bobbin 4 is not limited particularly and it is also allowed to select a liquid crystal polymer (LCP: Liquid Crystal Polymer), a diallyl phthalate (DAP: Diallyl Phthalate) or the like.

It should be noted that the concave portion recessed from the end surface of the external terminal may be formed, for example, based on embodiments illustratively shown in FIGS. 8 to FIGS. 9 other than those based on the exemplified embodiments mentioned above and the exemplified embodiments shown in FIGS. 6 and 7.
FIGS. 8 are plan views showing views with respect to another embodiment of the present invention. Here, FIG. 8A is a view in which concave portions 6B are formed by an amount of two portions at an external terminal 5E (there is shown only one terminal out of the external terminals positioned on both the sides of the bobbin 4). Also, FIG. 8B is a view showing a state after cutting a root portion (cut line 12 shown by a dotted line in FIG. 8A) of a connecting portion between the connection portion and the external terminal shown in FIG. 8A.

In a mode shown in FIG. 8A, the frame body (not shown) constituting the lead frame and the external terminal 5E are connected by a connection body 7E for connecting both the sides.
On both the sides of the connecting portion between this connection body 7E and the external terminal 5E, there are formed respectively post-shaped concave portions 6B which are recessed toward the external terminal 5E side (more specifically, toward the anti-protrusion direction of the external terminal 5E). Also, the width of the external terminal 5E (width of the right and left direction in FIG. 8A) is formed to be wider than the width of the connection body 7E. Further, the connection body 7E is connected to the external terminal 5E at the center position of the external terminal 5E in the right and left direction in FIG. 8A. The L-shaped concave portion 6B is, similarly as the exemplified embodiment mentioned above, formed when bending-processing & punching-processing a metal plate into a predetermined shape. Then, after the bending process & punching process, there is formed, on the surface, a solder plating layer. Then, the solder plating layers are formed also on the inner wall surfaces of the concave portions 6B. In addition, the plating layers are formed also on the end surfaces of the external terminal 5E, which are arranged on both the sides of the concave portions 6B. Thereafter, by applying the insert molding similarly as the exemplified embodiment mentioned above, the bobbin 4 is molded.

In FIG. 8B, similarly as in FIG. 5, there is shown a plan view of an external terminal 5F portion of a state in which the surface mounting component 1A is mounted on the mounting board. At the concave portions 6B, there are formed the solder fillets 11. In addition, the solder fillets 11 are formed also on end surfaces 5E3 except a cut surface 5E2 of the external terminal 5F. Accordingly, the joining strength of the solder after the surface mounting of the surface mounting component 1A becomes adequate. In addition to that configuration, the solder fillets 11 are continuously formed from the end surfaces 5E3 along the inner wall surfaces of the concave portions 6B. Consequently, the tolerance with respect to the plating peeling-off is improved.

Also, in a state of sandwiching the cut surface 5E2, the lined-up two concave portions 6B are formed plane-symmetrically by setting a plane surface passing through the center of the end surface (end surface on the side in which the cut surface 5E2 is formed) of the external terminal 5E and being perpendicular to the surface of the mounting board and the end surface as a symmetry plane. For this reason, after mounting the surface mounting component 1A on the mounting board, portions on which the solder fillets 11 are formed are arranged symmetrically on the side of the end surface. Consequently, it is possible, on the side of the end surface, to equalize the stress which is received by the melting solder on an occasion of the mounting and it is possible to repress the break caused by melting or the like which is caused by a phenomenon that the stress is applied to a portion of the melting solder excessively.
It should be noted that in the example shown in FIGS. 8, the shape of the concave portion 6B is formed in a square-rod shape, but it is also allowed to employ a roundish post shape, a semi elliptical shape or the like individually.

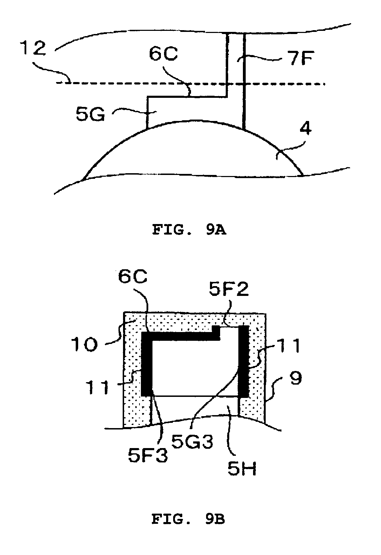

FIGS. 9 are plan views showing views with respect to another exemplified embodiment of the present invention. Here, FIG. 9A is a view in which the portions 6C are formed by an amount of two portions for the external terminals 5G (only one terminal out of the external terminals positioned on both the sides of the bobbin 4 is illustrated). Also, FIG. 9B is a view showing a state after cutting a root portion (cut line 12 shown by a dotted line in FIG. 9A) of a connecting portion between the connection portion and the external terminal shown in FIG. 9A.

In the mode shown in FIG. 9A, the frame body (not shown) constituting the lead frame and the external terminal 5G are connected by a connection body 7F for connecting both the sides.
On both the sides of the connecting portions between these connection bodies 7F and the external terminals 5G, there are formed respectively post-shaped concave portions 6C which are recessed toward the external terminal 5G sides (more specifically, toward the anti-protrusion directions of the external terminals 5G). Also, the width of the external terminal 5G (width of the right and left direction in FIG. 9A) is formed to be wider than the width of the connection body 7F. Further, the connection body 7F is connected to the external terminal 5G on one end side of the external terminal 5G in the right and left direction in FIG. 9A. The L-shaped concave portions 6C are, similarly as the exemplified embodiment mentioned above, formed when a metal plate is bending-processed & punching-processed into a predetermined shape. Then, after the bending process & punching process, a solder plating layer is formed on the surface. Then, the solder plating layer is formed also on the inner wall surface of the concave portion 6C. In addition, the plating layers are formed also on the end surfaces of the external terminal 5G, which are arranged on both the sides of the end surface on the side on which the concave portion 6C is formed. Thereafter, similarly as the exemplified embodiment mentioned above, the bobbin 4 is formed by applying the insert molding.

In FIG. 9B, similarly as in FIG. 5, there is shown a plan view of an external terminal 5H portion of a state in which the surface mounting component 1A is mounted on the mounting board. At the concave portion 6C, there is formed the solder fillet 11. In addition, the solder fillets 11 are formed also on end surfaces 5F3, 5G3 except a cut surface 5F2 of the external terminal 5H. Accordingly, the joining strength of the solder after the surface mounting of the surface mounting component 1A becomes adequate. Further, the solder fillets 11 which are formed on the end surface 5F3 and the inner wall surface of the concave portion 6C are continuously formed from the end surface 5F3 toward the inner wall surface of the concave portion 6C. For this reason, the tolerance with respect to the plating peeling-off is improved.
It should be noted that in the example shown in FIGS. 9, the shape of the concave portion 6C is formed in a square-rod shape, but it is also allowed to employ a roundish post shape, a semi elliptical shape or the like individually.

It is not particularly limited by the width of the concave portion (length in the cut surface direction) which is formed on the end surface of the external terminal. However, the longer the creepage distance for which the plate coating layer is formed is made, the more the region for which the solder fillet is formed increases, so that it is possible to improve the joining strength more.

## Claims

1. In a surface mounting component having an external terminal applied with a plate coating process, a surface mounting component **characterized in that**
at least one surface among the side surfaces of said external terminal is a cut surface which is formed by cutting off a connected member connected to said external terminal in a manufacturing process of said surface mounting component and from which a base material of said external terminal is exposed; and
a surface which is recessed from said end surface and also which is applied with a plate coating process is formed at somewhere of the end surface having said cut surface.

2. The surface mounting component according to claim 1, **characterized in that**
said cut surface is formed by cutting the external terminal in a state of being connected with said connected member from said connected member after said plate coating process is applied, and
said surface which is recessed from the end surface and also which is applied with a plate coating process is formed by being applied with said plate coating process after being cut so as to be recessed from said end surface.

3. The surface mounting component according to claim 1 or 2, **characterized in that** said surface which is recessed from the end surface and also which is applied with a plate coating process is formed plane-symmetrically by setting a plane surface passing through the center of said end surface and being perpendicular to the surface of said mounting board and said end surface as a symmetry plane.

4. The surface mounting component according to any one of claims 1 to 3, **characterized in that** said surface which is recessed from the end surface and also which is applied with a plate coating process is formed in a curved surface shape.
